# EUROPEAN PATENT SPECIFICATION

(11) **EP 1 717 875 B1**
(45) Date of publication and mention of the grant of the patent: **25.06.2008**
(21) Application number: 06111821.2
(22) Date of filing: 28.03.2006
(51) Int. Cl.: H01L 51/00, H01L 51/50

(54) **Organic light-emitting device**
Organische lichtemittierende Vorrichtung
Dispositif électroluminescent organique

(30) Priority: 31.03.2005 KR 20050027009
(43) Date of publication of application: 02.11.2006
(73) Proprietor: Samsung SDI Co., Ltd., Suwon-si Gyeonggi-do (KR)
(72) Inventor: Lee, Yun-Yeob Samsung SDI Co., Ltd., Gyeonggi-do (KR); Chun, Min-Seung Samsung SDI Co., Ltd., Gyeonggi-do (KR)
(74) Representative: Hengelhaupt, Jürgen

(56) References cited:
- US-A- 5 935 721
- US-B1- 6 582 837
- PATENT ABSTRACTS OF JAPAN vol. 2000, no. 21, 3 August 2001 (2001-08-03) -& JP 2001 097897 A (IDEMITSU KOSAN CO LTD), 10 April 2001 (2001-04-10)

## Description

### BACKGROUND OF THE INVENTION

### Field of the Invention

The present invention relates to a display device, and more particularly, to an organic light-emitting device.

### Description of the Related Technology

In general, an organic light-emitting device has a structure of an anode, a hole transport layer, a light -emitting layer, an electron transport layer, and a cathode sequentially formed on a substrate. An organic light-emitting device having such a structure operates based on the following principle.

When a voltage is applied between the anode and the cathode, holes that are injected from the anode move to the light-emitting layer through the hole transport layer. Meanwhile, electrons move from a cathode to the light-emitting layer through the electron transport layer. The holes and the electrons meet and recombine in the light-emitting layer, thereby generating hole-electron pairs, called excitons. The excitons transfer their energy to light emitting molecules to excite their electrons. When the excited electrons return to their ground states and release energy, the light -emitting molecules emit visible light. By having a number of organic light-emitting devices described above in a ma trix form, a display device is provided capable of displaying an image.

US 6,582,837 B1 discloses compounds used in light emitting layers in OLEDs comprising bianthracenes or trianthracenes or naphthyl anthracenes as a hole - or electron-transporting material. US 6,582,837 B1 does not disclose to use a combination of a bianthracene and a naphthyl anthracene in the light -emitting layer

Many attempts have been made to develop an organic light-emitting device having excellent performance. Conventional organic light-emitting devices, however, have exhibited undesirable colour characteristics and a short lifetime. Therefore, there is a need to develop an organic light-emitting device having excellent colour characteristics and a long lifetime.

### SUMMARY OF CERTAIN INVENTIVE ASPECTS

One aspect of the invention provides an organic light-emitting device. The organic light-emitting device comprises: a first electrode; a second electrode; and a light-emitting layer interposed between the first electrode and the second electrode, the light-emitting layer comprising a host and a dopant, the host comprising a naphthyl anthracene-based compound and a bianthracene-based compound.

In the device, the naphthyl anthracene-based compound may be represented by Formula 1: 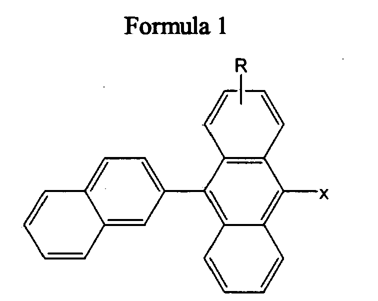 wherein R is selected from the group consisting of hydrogen, a substituted or unsubstituted C1-C20 alkyl group, a substituted or unsubstituted C1-C20 alkoxy group, a substituted or unsubstituted C6-C20 aryl group, a substituted or unsubstituted C6-C20 aryloxy group, and a substituted or unsubstituted C2-C20 heteroaryl group; wherein x is one selected from the group consisting of a substituted or unsubstituted naphthyl group, a substituted or unsubstituted biphenyl group, a substituted or unsubstituted naphthylphenyl group, and a substituted or unsubstituted anthracenylphenyl group.

The bianthracene-based compound may be represented by Formula 2: 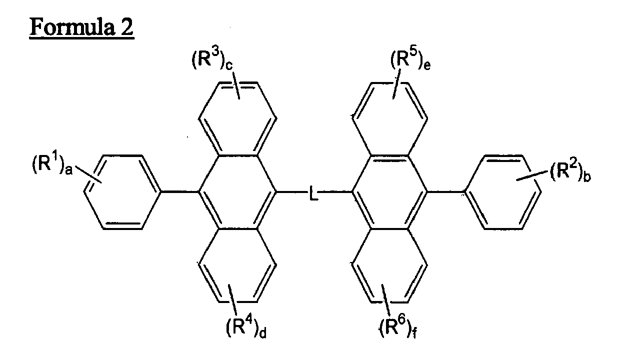 wherein each of R1 through R6 is independently selected from the group consisting of hydrogen, a substituted or unsubstituted C1-C20 alkyl group, a substituted or unsubstituted C5-C10 cycloalkyl group, a substituted or unsubstituted C2-C20 alkenyl group, a substituted or unsubstituted C6-C20 aryl group, a substituted or unsubstituted C1-C20 alkoxy group, a substituted or unsubstituted C6-C20 aryloxy group, a substituted or unsubstituted C1-C20 alkylamino group, a substituted or unsubstituted C6-C20 arylamino group, and a substituted or unsubstituted C2-C20 heterocyclic group, wherein one or more of R1 through R6 may form a ring by bonding to two or more benzene rings; wherein each of a and b is independently an integer of 0, 1, 2, 3, 4 or 5; wherein each of c, d, e, and f is independently an integer of 1, 2, 3 or 4; and wherein L is selected from the group consisting of no atom, -O-. - S-, -N(R')-, a C6-C20 arylene group and a C6-C20 aryl group, and R' is a C1-C10 alkyl group.

The compound represented by formula 1 may be the compound represented by Formula 3 or Formula 4:

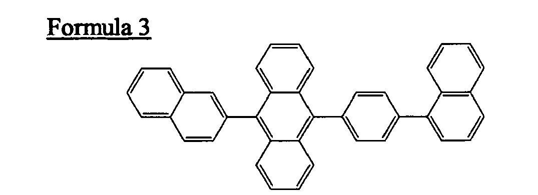

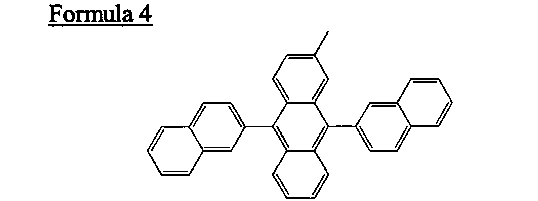

The compound represented by Formula 2 may be the compound represented by Formula 5 or Formula 6:

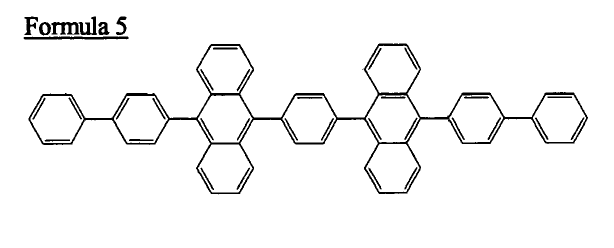

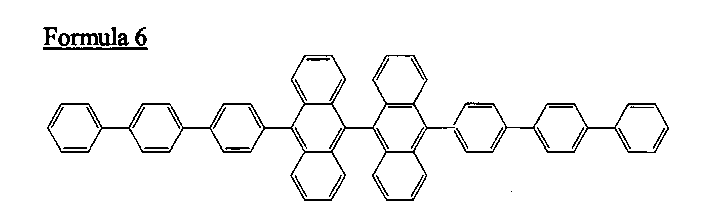

In the device, the dopant may comprise a blue light-emitting material. The dopant may comprise a compound represented by Formula 8: 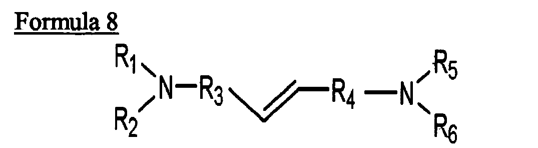 wherein R1, R2, R5, and R6 are each independently a substituted or unsubstituted C6-C20 aryl group; and wherein R3 and R4 are each independently a substituted or unsubstituted C6-C20 arylene group. The dopant may be one selected from the group consisting of a compound of Formula 8, in which each of R1, R2, R5, and R6 is a phenyl group, and each of R3 and R4 is a phenylene group; a compound of Formula 8, in which each of R1 and R5 is a phenyl group, each of R2 and R6 is a naphthyl group, and each of R3 and R4 is a phenylene group; and a compound of Formula 8, in which each of R1 and R5 is a naphthyl group, each of R2 and R6 is a phenyl group, and each of R3 and R4 is a naphthalene group.

The dopant may comprise the compound represented by Formula 7:

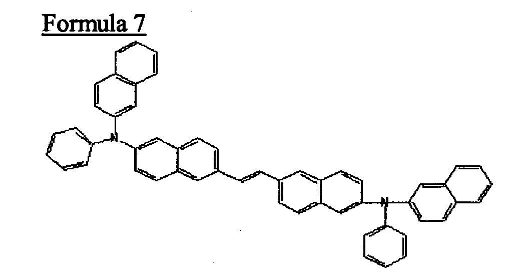

In the device, a weight ratio of the naphthyl anthracene-based compound to the bianthracene-based compound may be from about 10:90 to about 90:10. The weight ratio may be from about 25:75 to about 75:25. The dopant may be in an amount from about 3 to about 7 parts by weight based on 100 parts by weight of the naphthyl anthracene-based compound to the bianthracene-based compound.

The light-emitting layer may comprise a compound represented by Formula 3 and a compound represented by Formula 5:

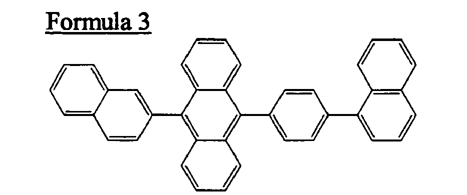

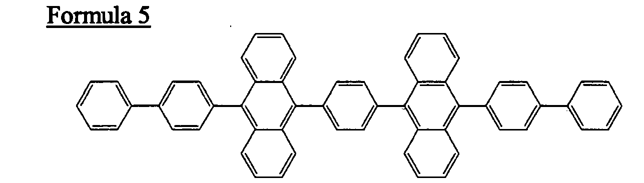

In the device, a weight ratio of the compound represented by Formula 3 to the compound represented by Formula 5 may be from about 75:25 to about 25:75. Tight-emitting layer may further comprise a dopant represented by Formula 7:

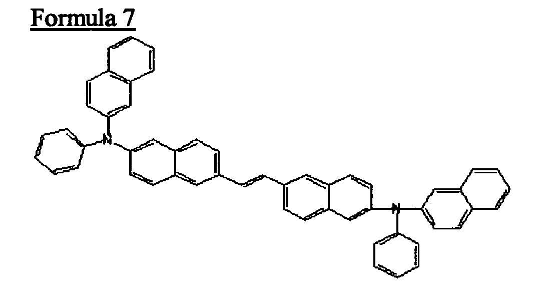

The dopant may be in an amount from about 3 to about 7 parts by weight based on 100 parts by weight of the naphthyl anthracene-based compound to the bianthracene-based compound.

The light-emitting layer may comprise a compound represented by Formula 3 and a compound represented by Formula 6:

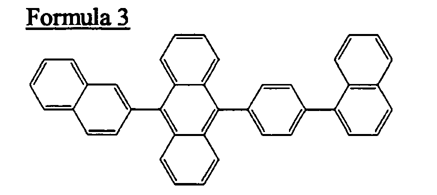

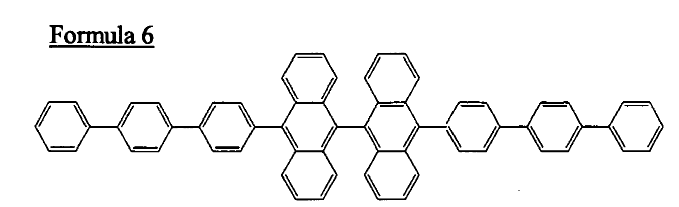

The light-emitting layer may further comprise a dopant represented by Formula 7:

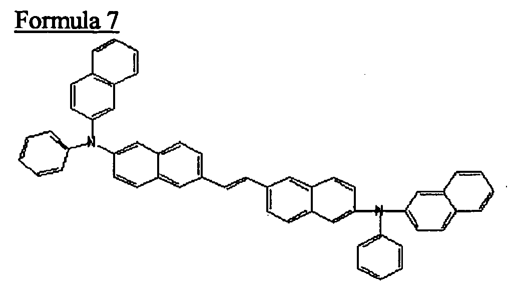

In the device the light-emitting layer may comprise a compound represented by Formula 4 and a compound represented by Formula 5:

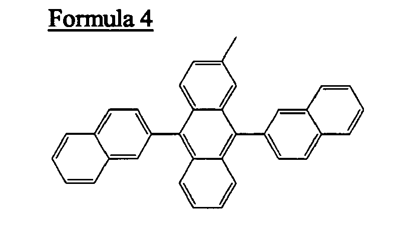

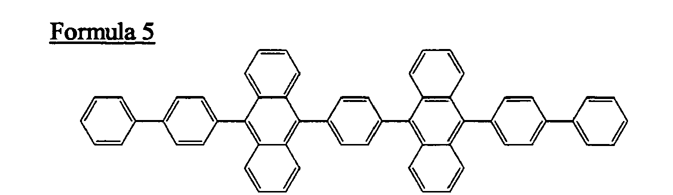

The light-emitting layer may further comprise a dopant represented by Formula 7

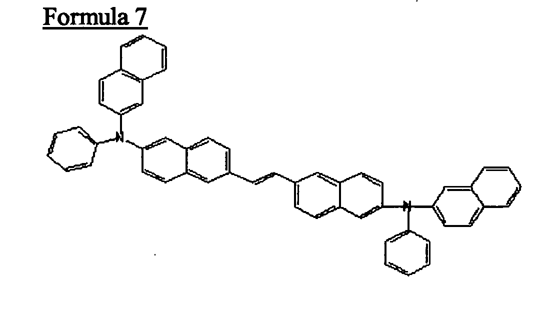

In the device, the light-emitting layer may comprise a compound represented by Formula 4 and a compound represented by Formula 6:

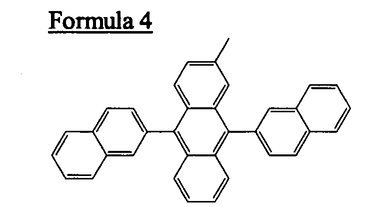

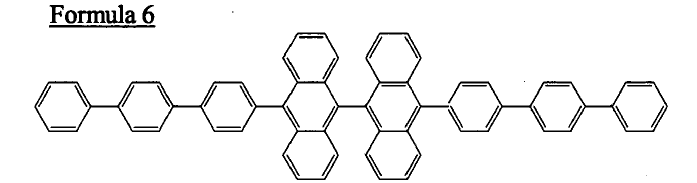

The light-emitting layer may further comprise a dopant represented by Formula 7:

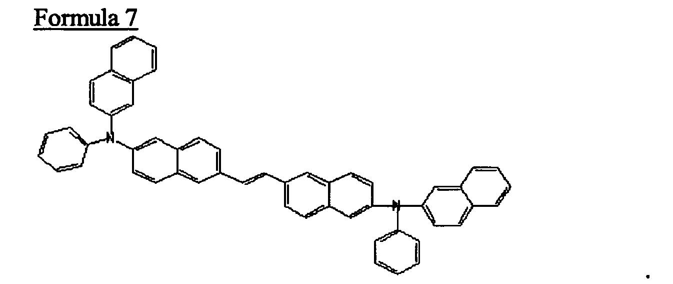

Another aspect of the invention provides an electronic device comprising the organic light-emitting device described above.

Yet another aspect of the invention provides an organic light-emitting device having excellent colour characteristics and a long lifetime including a light-emitting layer prepared using a mixed host and a dopant, and a method of manufacturing the same.

Another aspect of the invention provides an organic light-emitting device including a light-emitting layer interposed between a first electrode and a second electrode, wherein the light-emitting layer includes: a mixed host of a naphthyl anthracene-based compound and a bianthracene-based compound; and a dopant.

Yet another aspect of the invention provides a method of manufacturing the organic light-emitting device, wherein the light-emitting layer is formed using the mixed host of the naphthyl anthracene-based compound and the bianthracene-based compound and the dopant. The light-emitting layer may be formed using a vacuum depositing method, an inkjet printing method, or a laser transferring method.

### BRIEF DESCRIPTION OF THE DRAWINGS

Aspects and advantages of the invention will become apparent and more readily appreciated from the following description, taken in conjunction with the accompanying drawing.

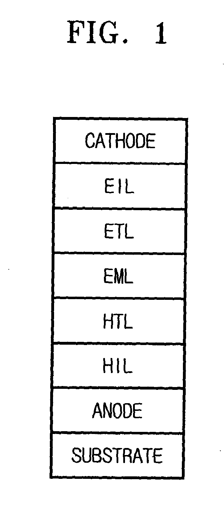

FIG. 1 illustrates a cross-sectional view of one embodiment of an organic light-emitting device.

### DETAILED DESCRIPTION OF CERTAIN INVENTIVE EMBODIMENTS

An organic light emitting device and a method of manufacturing the same according to embodiments of the invention will be described in detail with reference to the accompanying drawing.

As described above, an organic light-emitting device includes an anode, a hole transport layer HTL, a light-emitting layer EML, an electron transport layer EIL, and a cathode sequentially formed on a substrate. Among others, the light emitting layer may have various configurations. In one embodiment, the light emitting layer may have an inert host material and hole and electron transport materials doped into the inert host material. Details of such a configuration are disclosed in US Patent Nos. 6,392,250; and 6,392,339, and US Patent Application Publication 2002/0098379, the disclosures of which are incorporated herein by reference.

According to an embodiment of the present invention, a light-emitting layer of a light-emitting device includes a naphthyl anthracene-based compound and a bianthracene-based compound as host materials. The host materials efficiently trap charges injected into the light-emitting layer, and thus improve stability of the light-emitting device and enhance color characteristics. Particularly, the naphthyl anthracene-based compound increases the stability of the device and the bianthracene-based compound improves colour characteristics of the device.

In one embodiment, the naphthyl anthracene-based compound is represented by Formula 1 below:

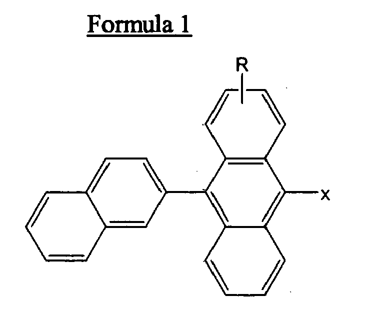

In Formula 1, R is selected from hydrogen, a substituted or unsubstituted C1-C20 alkyl group, a substituted or unsubstituted C1-C20 alkoxy group, a substituted or unsubstituted C6-C20 aryl group, a substituted or unsubstituted C6-C20 aryloxy group, and a substituted or unsubstituted C2-C20 heteroaryl group.

Examples of the C1-C20 alkyl group include, but are not limited to, methyl, ethyl, propyl, isobutyl, sec-butyl, pentyl, iso-amyl, and hexyl. Examples of the C1-C20 alkoxy group include, but are not limited to, methoxy, ethoxy, phenyloxy, cyclohexyloxy, naphthyloxy, isopropyloxy, and diphenyloxy. The substituted or unsubstituted C6-C20 aryl group may be used alone or in combination to be an aromatic carbon cycling system including at least one cycle that may be pendent to each other or fused. Examples of the aryl group include, but are not limited to, phenyl, naphthyl, and tetrahydronaphthyl. Examples of the aryloxy group include, but are not limited to, phenyloxy, naphthyleneoxy, and diphenyloxy. The substituted or unsubstituted heteroaryl group refers to a monovalent monocyclic or bivalent bicyclic aromatic organic compound of C6 to C20 which includes one, two, or three heteroatoms selected from N, O, P and S and the remaining cyclic atoms are C. Examples of the heteroaryl group include, but are not limited to, thienyl, pyridyl, and furyl.

The substituted C1-C20 alkyl group, the substituted C1-C20 alkoxy group, the substituted C6-C20 aryl group, the substituted C6-C20 aryloxy group, and the substituted C2-C20 heteroaryl group may be substituted with one or more substituent groups selected from halogen, a hydroxyl group, a nitro group, a cyano group, an amino group, an amidino group, hydrazine, hydrazone, a carboxyl group or a salt thereof, a sulfonic acid or a salt thereof, a phosphoric acid or a salt thereof, a C1-C30 alkyl group, a C1-C30 alkenyl group, a C1-C30 alkynyl group, a C6-C30 aryl group, a C7-C30 arylalkyl group, a C2-C20 heteroaryl group, or a C3-C30 heteroarylalkyl group. Each y is independently an integer of 0 to 4. z is an integer of 0 to 3.

x is selected from a substituted or unsubstituted naphthyl group, a substituted or unsubstituted biphenyl group, a substituted or unsubstituted naphthylphenyl group, and a substituted or unsubstituted anthracenylphenyl group. In the substituted forms of these substituent groups, one or more hydrogen positions may be substituted with one or more substituent groups selected from a substituted or unsubstituted C1-C20 alkyl group, a substituted or unsubstituted C1-C20 alkoxy group, a substituted or unsubstituted C6-C20 aryl group, a substituted or unsubstituted C6-C20 aryloxy group, and a substituted or unsubstituted C2-C20 heteroaryl group. The substituted C1-C20 alkyl group, the substituted C1-C20 alkoxy group, the substituted C6-C20 aryl group, the substituted C6-C20 aryloxy group, and the substituted C2-C20 heteroaryl group may be substituted with one or more substituent group selected from a halogen atom, a hydroxyl group, a nitro group, a cyano group, an amino group, an amidino group, hydrazine, hydrazone, a carboxyl group or a salt thereof, a sulfonic acid or a salt thereof, a phosphoric acid or a salt thereof, a C1-C30 alkyl group, a C1-C30 alkenyl group, a C1-C30 alkynyl group, a C6-C30 aryl group, a C7-C30 arylalkyl group, a C2-C20 heteroaryl group, or a C3-C30 heteroarylalkyl group.

In another embodiment, the naphthyl anthracene-based compound is represented by Formula 1-2:

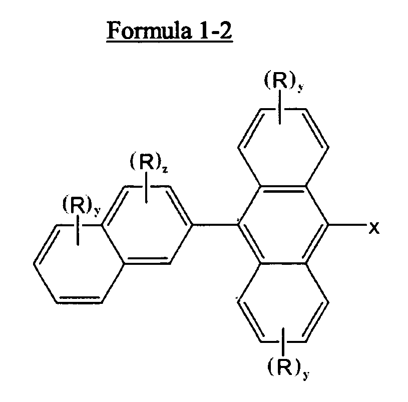

In Formula 1-2, each R is independently hydrogen, a substituted or unsubstituted C1-C20 alkyl group, a substituted or unsubstituted C1-C20 alkoxy group, a substituted or unsubstituted C6-C20 aryl group, a substituted or unsubstituted C6-C20 aryloxy group, and a substituted or unsubstituted C2-C20 heteroaryl group. y is independently an integer of 0, 1, 2, 3 or 4. z is an integer of 0, 1, 2 or 3. When two or more R is attached to a single benzene ring, each of R's is independently selected from the foregoing substituent groups. x is selected from the same substituent groups as provided above in connection with Formula 1.

In one embodiment, the compound of Formula 1 or 1-2 (collectively Formula 1) may be a compound represented by Formula 3 or a compound represented by Formula 4:

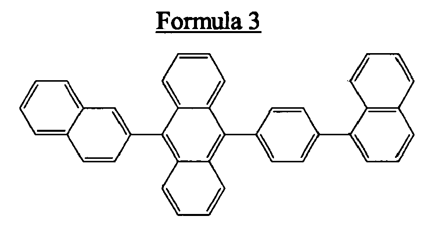

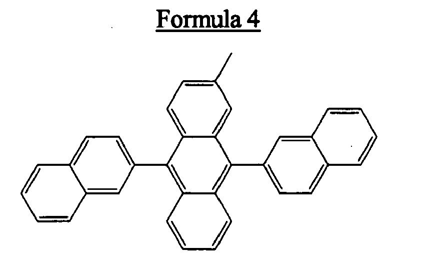

Further examples of the naphthyl anthracene-based compound represented by Formula 1 are disclosed in U.S. Patent No. 5,935,721, the disclosure of which is incorporated herein by reference. The naphthyl anthracene-based compounds in accordance with embodiments of the invention can be synthesized by the same method as that disclosed in U.S. Patent No. 5,935,721.

In one embodiment, the bianthracene-based compound described above may be represented by Formula 2:

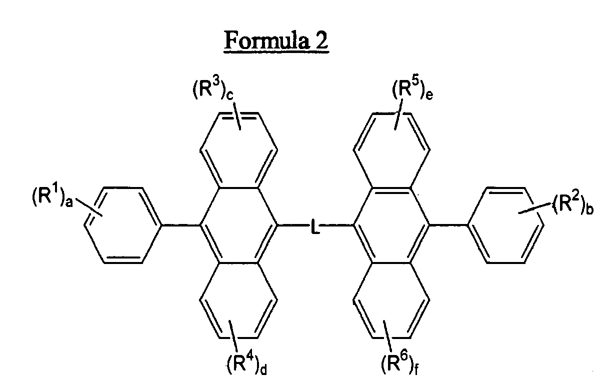

In Formula 2, R1 through R6 are each independently hydrogen, a substituted or unsubstituted C1-C20 alkyl group, a substituted or unsubstituted C5-C10 cycloalkyl group, a substituted or unsubstituted C2-C20 alkenyl group, a substituted or unsubstituted C6-C20 aryl group, a substituted or unsubstituted C1-C20 alkoxy group, a substituted or unsubstituted C6-C20 aryloxy group, a substituted or unsubstituted C1-C20 alkylamino group, a substituted or unsubstituted C6-C20 arylamino group, a substituted or unsubstituted C2-C20 heterocyclic group, or a substituted or unsubstituted C6-C20 arylene group.

Examples of the C1-C20 alkyl group include, but are not limited to, methyl, ethyl, propyl, isobutyl, sec-butyl, pentyl, iso-amyl, hexyl. Examples of the C5-C10 cycloalkyl group include, but are not limited to, a cyclohexyl group, and a cyclopentyl group. The substituted or unsubstituted C6-C20 aryl group may be used alone or in combination to be an aromatic carbon cycling system including at least one cycle that may be pendent to each other or fused. Examples of the aryl group include, but are not limited to, phenyl, naphthyl, and tetrahydronaphthyl. Examples of the C1-C20 alkoxy group include, but are not limited to, methoxy, ethoxy, phenyloxy, cyclohexyloxy, naphthyloxy, isopropyloxy, and diphenyloxy. Examples of the aryloxy group include, but are not limited to, phenyloxy, naphthyleneoxy, and diphenyloxy. Examples of the C1-C20 alkylamino group include, but are not limited to, a dimethylamino group. Examples of the C6-C20 arylamino group include, but are not limited to, a diphenylamino group. The substituted or unsubstituted heterocyclic group includes aliphatic or aromatic cyclic groups with one ore more hetero atoms such as N, O, P and S. Examples of the heterocyclic group include, but are not limited to, thienyl, pyridyl, and furyl. Examples of the C6-C20 arylene group include, but are not limited to, phenylene, and biphenylene.

In Formula 2, the substituted C1-C20 alkyl group, the substituted C5-C10 cycloalkyl group, the substituted C2-C20 alkenyl group, the substituted C6-C20 aryl group, the substituted C1-C20 alkoxy group, the substituted C6-C20 aryloxy group, the substituted C1-C20 alkylamino group, the substituted C6-C20 arylamino group, the substituted C2-C20 heterocyclic group, and the C6-C20 arylene group may be substituted with one or more substituent group selected from a halogen atom, a hydroxyl group, a nitro group, a cyano group, an amino group, an amidino group, hydrazine, hydrazone, a carboxyl group or a salt thereof, a sulfonic acid or a salt thereof, a phosphoric acid or a salt thereof, a C1-C30 alkyl group, a C1-C30 alkenyl group, a C1-C30 alkynyl group, a C6-C30 aryl group, a C7-C30 arylalkyl group, a C2-C20 heteroaryl group, or a C3-C30 heteroarylalkyl group.

In Formula 2, a and b are each independently an integer of 0, 1, 2, 3, 4 or5. c, d, e, and f are each independently an integer of 1, 2, 3 or 4. In Formula 2, a plurality of groups denoted by each of R1 through R6 are the same as or different from each other. In some embodiments, one or more of R¹ through R⁶ may form a ring by bonding to two or more benzene rings. In one embodiment, L represents direct connection (no atom) between the two anthracenyl groups of Formula 2. In other embodiments, L represents -O-, -S-, -N(R')-, or a C6-C20 arylene group, where R' is a C1-C10 alkyl group or a C6-C20 aryl group.

In one embodiment, the compound represented by Formula 2 may be a compound represented by Formula 5 or a compound represented by Formula 6 below:

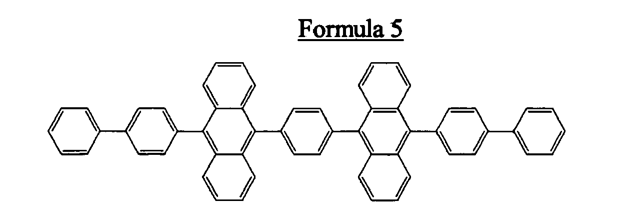

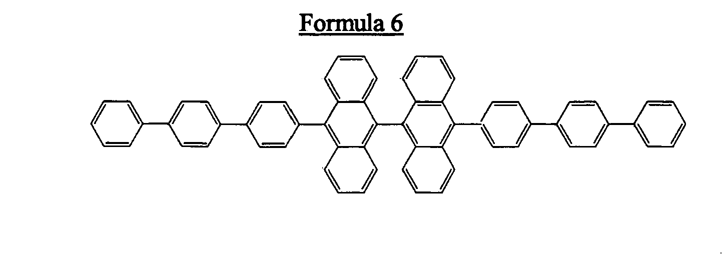

As host materials, the naphthyl anthracene-based compound and the bianthracene-based compound may be mixed with a weight ratio of between about 10:90 to about 90:10, optionally between about 75:25 to about 25:75.

In the light-emitting layer, a number of different dopant materials known in the art may be used in combination with the host materials as discussed above. A single dopant material can be used alone in the light-emitting layer. In the alternative, two or more dopant materials can be used together in a single light-emitting layer. According to an embodiment, the dopant may be, but is not limited to, one or more compounds represented by Formula 8 below:

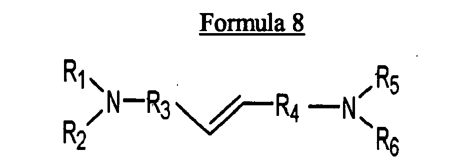

Formula 8, R1, R2, R5, and R6 are each independently a substituted or unsubstituted C6-C20 aryl group; and R3 and R4 are each independently a substituted or unsubstituted C6-C20 arylene group. The substituted or unsubstituted C6-C20 aryl group may be used alone or in combination to be an aromatic carbon cycling system including at least one cycle that may be pendent to each other or fused. Examples of the aryl group include, but are not limited to, phenyl, naphthyl, and tetrahydronaphthyl. Examples of the C6-C20 arylene group include, but are not limited to, phenylene, and biphenylene.

The substituted C6-C20 aryl group and the substituted C6-C20 arylene group may be substituted with one or more substituent groups selected from a halogen atom, a hydroxyl group, a nitro group, a cyano group, an amino group, an amidino group, hydrazine, hydrazone, a carboxyl group or a salt thereof, a sulfonic acid or a salt thereof, a phosphoric acid or a salt thereof, a C1-C30 alkyl group, a C1-C30 alkenyl group, a C1-C30 alkynyl group, a C6-C30 aryl group, a C7-C30 arylalkyl group, a C2-C20 heteroaryl group, or a C3-C30 heteroarylalkyl group.

In certain embodiments, the dopant may be one or more compounds represented by Formula 8, where R1, R2, R5, and R6 are phenyl groups, and R3 and R4 are phenylene groups; a compound represented by Formula 8 where R1 and R5 are phenyl groups, R2 and R6 are naphthyl groups, and R3 and R4 are phenylene groups; or a compound represented by Formula 8 where R1 and R5 are naphthyl groups, R2 and R6 are phenyl groups, and R3 and R4 are naphthalene groups.

The light-emitting layer according to an embodiment may include, as host materials, the compound represented by Formula 3 and the compound represented by Formula 5. In one embodiment, the weight ratio of the compound of Formula 3 to the compound of Formula 5 is between about 75:25 and about 25:75. In the embodiment, the dopant may be a compound represented by Formula 7 below. The dopant may be in an amount of about 3 to about 7 parts by weight based on 100 parts by weight of the host materials.

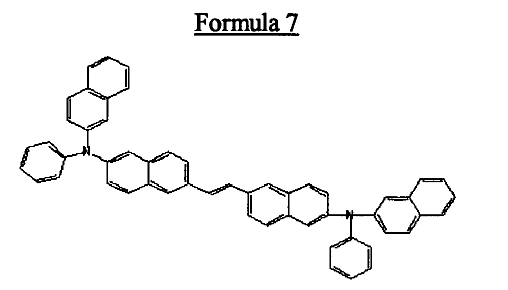

A method of manufacturing an organic light-emitting device according to one embodiment will now be described in detail with reference to FIG. 1.

First, an anode material is coated on a substrate to form a first electrode serving as an anode. The substrate may be formed of a transparent material which is waterproof and easily processable to form a planar surface. Examples of such material include glass or transparent polymers. The anode material may be a metal with a high work function (≥ -4.5eV) or a conductive transparent material, such as indium tin oxide (ITO), indium zinc oxide (IZO), tin oxide (SnO2), or zinc oxide (ZnO).

Organic thin layers on the anode may be formed by thermal evaporation in a high vacuum chamber. Alternatively, depending on the materials for the organic thin layers, the materials may be dissolved in a solution and applied onto the substrate by spin coating, dip coating, doctor blading, inkjet printing or thermal transferring.

A hole injection layer (HIL) material is optionally deposited on the anode using any suitable method. The HIL may have a thickness of between about 5 nm (50 Å) and about 150 nm (1500 Å). Examples of the HIL material include, but are not limited to, copper phthalocyanine (CuPc) and a starburst-type amine, such as TCTA (Formula 9), m-MTDATA (Formula 10), and IDE406 (commercially available from Idemitsu Inc.).

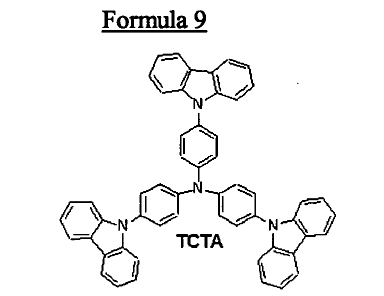

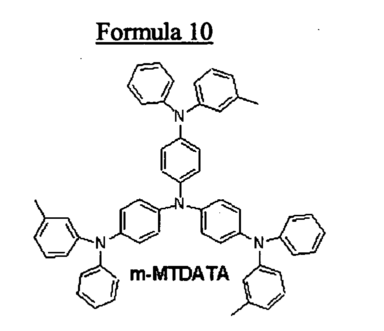

A hole transport layer (HTL) material is optionally deposited on the HIL using any suitable method. Examples of the HTL material include, but are not limited to, N,N'-bis(3-methylphenyl)-N,N'-diphenyl-[1,1-biphenyl]-4,4'-diamine(TPD; Formula 11); N,N'-di(naphthalene-1-yl)-N,N'-diphenyl benzidine (NPD; Formula 12); IDE320 (commercially available from Idemitsu Inc.); and N,N'-diphenyl-N,N'-bis(1-naphthyl)-(1,1'-biphenyl)-4,4'-diamine (NPB). The HTL may have a thickness of between about 5 nm (50 Å) and about 150 nm (1500 Å).

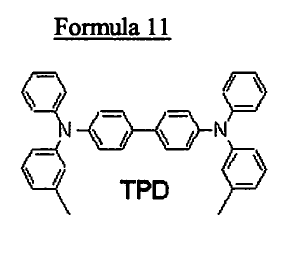

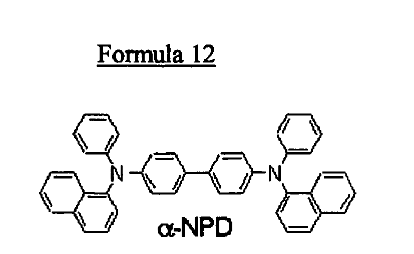

Subsequently, a dopant, a naphtylanthracene-based compound and a bianthracene-based compound are provided together to form a light-emitting layer (EML) on the HTL. The EML may be formed by a method, including, but not limited to, a vacuum depositing method, an ink-jet printing method, a laser transferring method, or a photolithographic method. The EML may have a thickness of between about 10 nm (100 Å) and about 80 nm (800 Å), optionally between about 30 nm (300 Å) and about 40 nm (400 Å).

When a phosphorescent dopant is used for the EML, a hole blocking layer (HBL) (not shown) may be optionally formed on the EML by vacuum depositing or spin coating.

Subsequently, an electron transport layer (ETL) is formed on the EML by vacuum deposition or spin coating. The ETL may be formed of tris(8-hydroxyquinoline)aluminum (Alq3.) The ETL may have a thickness of between about 5 nm (50 Å) and about 60 nm (600 Å).

An electron injection layer (EIL) may optionally be deposited on the ETL. The EIL may be formed of LiF, NaCl, CsF, Li2O, BaO, or Liq (Formula 13). The EIL may have a thickness of between about 0.1 nm (1 Å) and about 10 nm (100 Å).

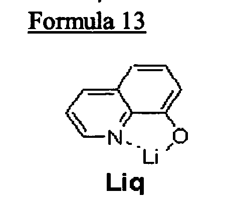

Then, a cathode metal is deposited on the EIL by vacuum thermal deposition, sputtering, or the like, thus forming a second electrode serving as a cathode. The cathode may be formed of Li, Mg, Al, Al-Li, Ca, Mg-In, or Mg-Ag.

In certain embodiments, one or two intermediate layers may be further provided between two layers selected from an anode, a HIL, a HTL, an EML, an ETL, an EIL, and a cathode. In addition, the organic light-emitting device may further include an electron blocking layer.

Another aspect of the invention provides an electronic device including an organic light-emitting device described above. In one embodiment, the electronic device includes a plurality of pixels, each of which includes a pixel driving circuit and the organic light-emitting device described above. The electronic device may include, but is not limited to consumer electronic products, electronic circuits, electronic circuit components, parts of the consumer electronic products, electronic test equipments, etc. The consumer electronic products may include, but are not limited to, a mobile phone, a telephone, a television, a computer monitor, a computer, a hand-held computer, a personal digital assistant (PDA), a microwave, a refrigerator, a stereo system, a cassette recorder or player, a DVD player, a CD player, a VCR, an MP3 player, a radio, a camcorder, a camera, a digital camera, a portable memory chip, a washer, a dryer, a washer/dryer, a copier, a facsimile machine, a scanner, a multi functional peripheral device, a wrist watch, a clock, etc. Further, the electronic device may include unfinished products.

The present invention will be described in further detail with reference to the following examples. These examples are for illustrative purposes only and are not intended to limit the scope of the present invention.

### Example 1

A 15Ω /cm² (120 nm/1200 Å) ITO glass substrate (commercially available from Corning Inc.) was cut to a size of 50 mm x 50 mm x 0.7 mm. The glass substrate was ultrasonically cleaned in isopropyl alcohol for 5 minutes, ultrasonically cleaned in pure water for 5 minutes, cleaned using ultraviolet (UV) rays for 30 minutes, and then cleaned using ozone.

N,N'-di(1-naphthyl)-N,N'-diphenylbenzidine (NPD) was vacuum deposited on the glass substrate to form a HTL having a thickness of 60 nm (600 Å).

A host of 75 parts by weight of the compound represented by Formula 3 and 25 parts by weight of the compound represented by Formula 5 and a dopant of 5 parts by weight of the compound represented by Formula 7 were vacuum deposited to form an EML having a thickness of about 40 nm (400 Å).

Alq3 as an electron transport material was deposited on the EML to form an ETL having a thickness of about 30 nm (300 Å).

LiF was vacuum deposited on the ETL to form an EIL having a thickness of 1 nm (10 Å) and then Al was vacuum deposited on the EIL to form a cathode having a thickness of 100 nm (1000 Å). As a result, a LiF/A1 electrode was formed and thus an organic light-emitting device was completely manufactured.

### Example 2

An organic light-emitting device was manufactured in the same manner as in Example 1, except that the compound represented by Formula 3 and the compound represented by Formula 5 had amounts of 50 parts by weight and 50 parts by weight, respectively, to form the EML.

### Example 3

An organic light-emitting device was manufactured in the same manner as in Example 1, except that the compound represented by Formula 3 and the compound represented by Formula 5 had amounts of 25 parts by weight and 75 parts by weight, respectively, to form the EML.

### Example 4

An organic light-emitting device was manufactured in the same manner as in Example 1, except that the compound represented by Formula 4 was used instead of the compound represented by Formula 3 to form the EML layer.

### Example 5

An organic light-emitting device was manufactured in the same manner as in Example 1, except that the compound represented by Formula 6 was used instead of the compound represented by Formula 5 to form the EML layer.

### Example 6

An organic light-emitting device was manufactured in the same manner as in Example 1, except that the compound represented by Formula 4 was used instead of the compound represented by Formula 3, and the compound represented by Formula 6 was used instead of the compound represented by Formula 5 to form the EML layer.

### Comparative Example 1

An organic light-emitting device was manufactured in the same manner as in Example 1, except that the EML was formed using the compound represented by Formula 3 as a host and the compound represented by Formula 7 as a dopant.

### Comparative Example 2

An organic light-emitting device was manufactured in the same manner as in Example 1, except that the EML was formed using the compound represented by Formula 5 as a host and the compound represented by Formula 7 as a dopant.

### Example 7

Colour characteristics, efficiency, and lifetime characteristics of the organic light-emitting devices prepared according to Examples 1 through 6 and Comparative Example 1 through 2 were measured. The results are shown in Table 1 below. The colour characteristics were measured using a spectrometer. The efficiency was measured using luminance and electric current values. The lifetime was measured using a constant current at a luminance of 2000 cd/m².

**Table 1**

| | Colour Coordinate (x, y) | Efficiency (cd/A) | Lifetime (hr) |
|---|---|---|---|
| Example 1 | (0.14,0.150) | 5.3 | 1100 |
| Example 2 | (0.14, 0.145) | 5.3 | 1000 |
| Example 3 | (0.14, 0.143) | 5.3 | 1000 |
| Example 4 | (0.14, 0.150) | 5.3 | 1100 |
| Example 5 | (0.14,0.142) | 5.4 | 900 |
| Example 6 | (0.14,0.140) | 5.3 | 900 |
| Comparative Example 1 | (0.14, 0.158) | 5.3 | 800 |
| Comparative Example 2 | (0.14, 0.147) | 5.0 | 400 |

Referring to Table 1, when compared with the organic light-emitting device prepared according to Comparative Example 1, the organic light-emitting devices prepared according to Examples 1 through 3 exhibited improved colour characteristics and lifetime characteristics, and the same efficiency. On the other hand, when compared with the organic light-emitting device prepared according to Comparative Example 2, the organic light-emitting devices prepared according to Examples 1 through 3 exhibited improved lifetime characteristics and efficiency.

The organic light-emitting device prepared according to Comparative Example 1 exhibited good lifetime characteristics and efficiency and poor colour characteristics. The organic light-emitting device prepared according to Comparative Example 2 exhibited good colour characteristics, low efficiency, and a short lifetime.

The organic light-emitting devices prepared according to Examples 4 through 6 exhibited similar colour characteristics, lifetime, and efficiency to the organic light-emitting devices prepared according to Examples 1 through 3.

### Additional Examples

Organic light-emitting devices are manufactured in the same manner as in Example 1, except that one naphthyl anthracene-based compound is used instead of the compound represented by Formula 3 and that one bianthracene-based compound is used instead of the compound represented by Formula 5. The one naphthyl anthracene-based compound is each of the naphthyl anthracene-based compounds disclosed in this application and U. S. Patent No. 5,935,721, the disclosure of which is incorporated herein by reference. The one bianthracene-based compound is each of the bianthracene-based compounds disclosed in this application including the compound of Formula 5. Each of the resulting organic light-emitting devices is tested for colour characteristics, efficiency, and lifetime characteristics in the same manner as Example 7.

A light-emitting layer of an organic light-emitting device according to the above embodiments includes a host of a naphthylanthracene-based compound and a bianthracene-based compound and a dopant. Therefore, charges injected into the light-emitting layer are trapped so that stability of the organic light-emitting device is enhanced. As a result, the organic light-emitting device exhibits a long lifetime, excellent colour characteristics, and high efficiency.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An organic light-emitting device, comprising:
a first electrode;
a second electrode; and
a light-emitting layer interposed between the first electrode and the second electrode, the light-emitting layer comprising a host and a dopant, the host comprising a naphthyl anthracene-based compound and a bianthracene -based compound.

2. The device of Claim 1, wherein the naphthyl anthracene-based compound is represented by Formula 1: 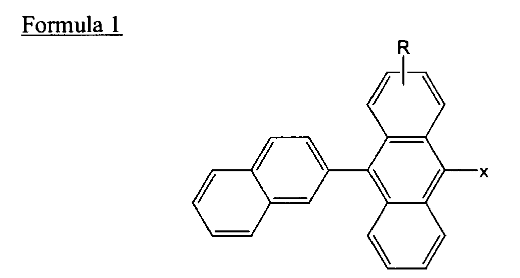 wherein R is selected from the group consisting of hydrogen, a substituted or unsubstituted C 1-C20 alkyl group, a substituted or unsubstituted C1-C20 alkoxy group, a substituted or unsubstituted C6-C20 aryl group, a substituted or unsubstituted C6-C20 aryloxy group, and a substituted or unsubstituted C2-C20 heteroaryl group;
wherein x is selected from the group consisting of a substituted or unsubstituted naphthyl group, a substituted or unsubstituted biphenyl group, a substituted or unsubstituted naphthylphenyl group, and a substituted or unsubstituted anthracenylphenyl group.

3. The device of Claims 1 or 2, wherein the bianthracene-based compound is represented by Formula 2: 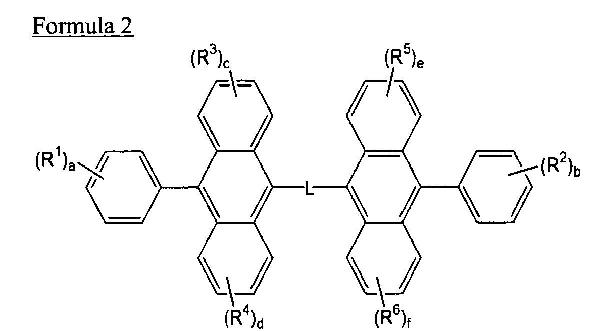 wherein each of R¹ through R⁶ is independently selected from the group consisting of hydrogen, a substituted or unsubstituted C1-C20 alkyl group, a substituted or unsubstituted C5-C10 cycloalkyl group, a substituted or unsubstituted C2-C20 alkenyl group, a substituted or unsubstituted C6 -C20 aryl group, a substituted or unsubstituted C1-C20 alkoxy group, a substituted or unsubstituted C6-C20 aryloxy group, a substituted or unsubstituted C1-C20 alkylamino group, a substituted or unsubstituted C6-C20 arylamino group, and a substituted or unsubstituted C2-C20 heterocyclic group, wherein one or more of R¹ through R⁶ may form a ring by bonding to two or more benzene rings;
wherein each of *a* and *b* is independently an integer of 0, 1, 2, 3, 4 or 5;
wherein each of *c*, *d, e*, and *f* is independently an integer of 1, 2, 3 or 4; and
wherein *L* is selected from the group consisting of no atom, -O-. -S-, -N(R')-, a C6-C20 arylene group and a C6-C20 aryl group, and R' is a C1-C10 alkyl group.

4. The device of Claim 2, wherein the compound represented by formula 1 is the compound represented by Formula 3 or Formula 4:

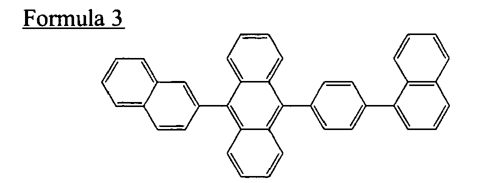

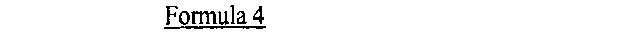

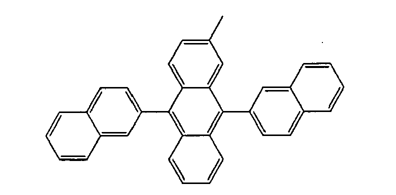

5. The device of Claim 3, wherein the compound represented by Formula 2 is the compound represented by Formula 5 or Formula 6:

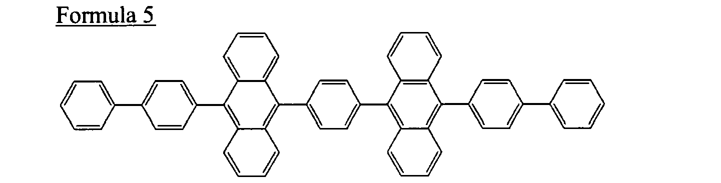

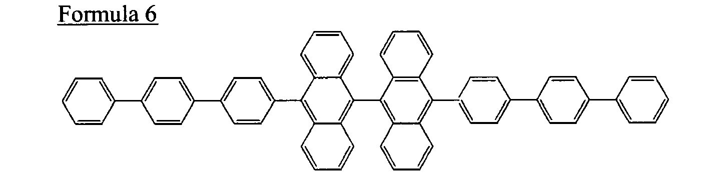

6. The device according to one of the preceding claims, wherein the dopant comprises a blue light-emitting material.

7. The device according to one of the preceding claims, wherein the dopant comprises a compound represented by Formula 8: 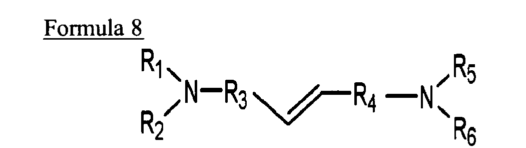 wherein R₁, R₂, R₅, and R₆ are each independently a substituted or unsubstituted C6-C20 aryl group; and
wherein R₃ and R₄ are each independently a substituted or unsubstituted C6-C20 arylene group.

8. The device of Claim 7, wherein the dopant is one selected from the group consisting of
a compound of Formula 8, in which each of R₁, R₂, R₅, and R₆ is a phenyl group, and each of R₃ and R₄ is a phenylene group;
a compound of Formula 8, in which each of R₁ and R₅ is a phenyl group, each of R₂ and R₆ is a naphthyl group, and each of R₃ and R₄ is a phenylene group; and
a compound of Formula 8, in which each of R₁ and R₅ is a naphthyl group, each of R₂ and R₆ is a phenyl group, and each of R₃ and R₄ is a naphthalene group.

9. The device of Claim 7 or 8, wherein the dopant comprises the compound represented by Formula 7:

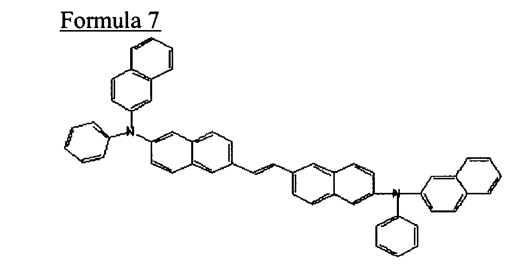

10. The device according to one of the preceding claims, wherein a weight ratio of the naphthyl anthracene-based compound to the bianthracene-based compound is from about 10:90 to about 90:10, in particular from about 25:75 to about 75:25.

11. The device according to one of the preceding claims, wherein the dopant is in an amount from about 3 to about 7 parts by weight based on 100 parts by weight of the host materials.

12. The device according to one of the preceding Claims 1 to 11, wherein the light-emitting layer comprises a compound represented by Formula 3 and a compound represented by Formula 5:

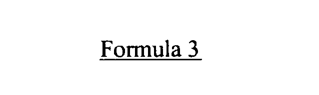

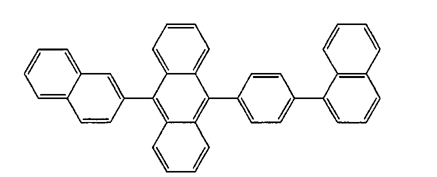

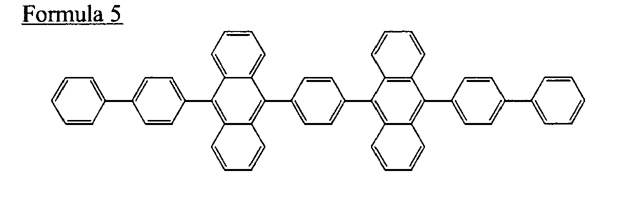

13. The device of Claim 12, wherein a weight ratio of the compound represented by Formula 3 to the compound represented by Formula 5 is from about 75:25 to about 25:75.

14. The device of Claim 12 or 13, wherein the light-emitting layer further comprises a dopant represented by Formula 7

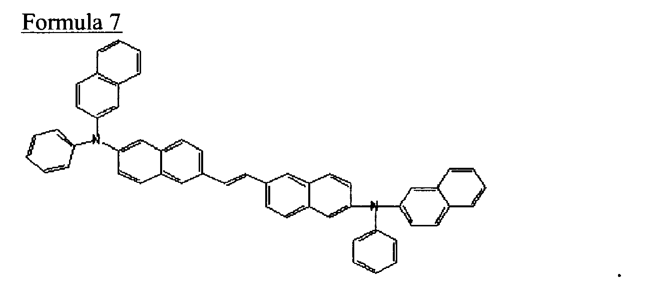

15. The device of Claim 14, wherein the dopant is in an amount from about 3 to about 7 parts by weight based on 100 parts by weight of the host materials.

16. The device according to one of the preceding Claims 1 to 11, wherein the light-emitting layer comprises a compound represented by Formula 3 and a compound represented by Formula 6:

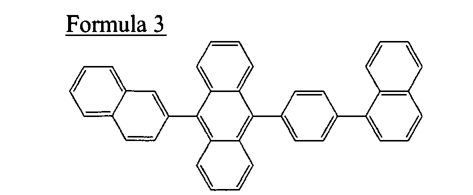

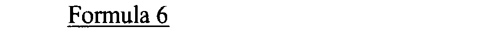

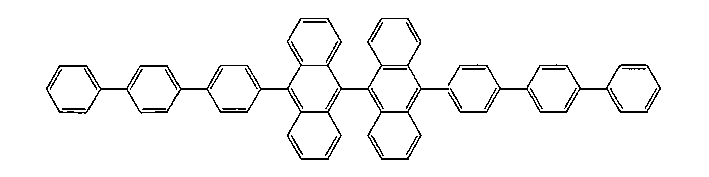

17. The device according to one of the preceding Claims 1 to 11, wherein the light-emitting layer comprises a compound represented by Formula 4 and a compound represented by Formula 5:

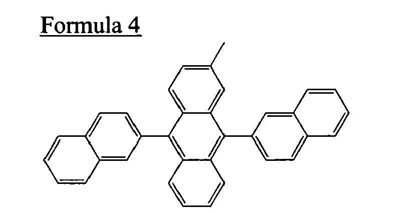

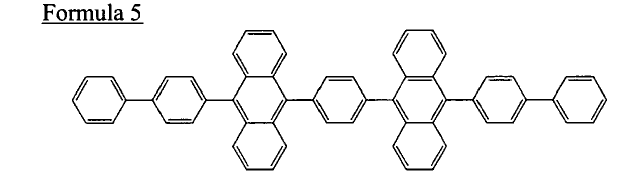

18. The device according to one of the preceding Claims 1 to 11, wherein the light-emitting layer comprises a compound represented by Formula 4 and a compound represented by Formula 6:

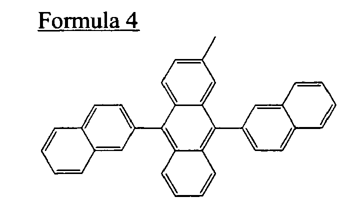

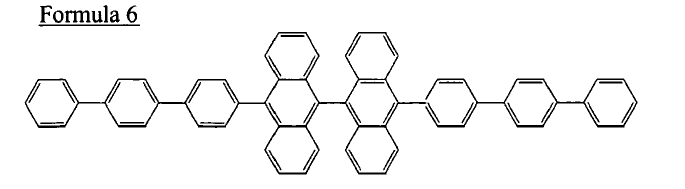

19. The device of Claim 16, 17 or 18, wherein the light-emitting layer further comprises a dopant represented by Formula 7:

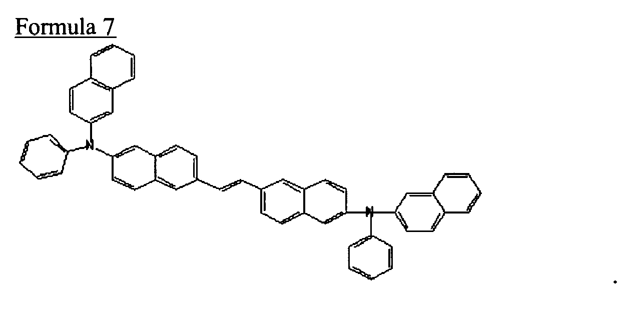

20. An electronic display device comprising at least one organic light -emitting device according to one of Claims 1 to 19.

## Patentansprüche

1. Eine organische lichtemittierende Vorrichtung, umfassend:
eine erste Elektrode;
eine zweite Elektrode; und
eine zwischen der ersten Elektrode und der zweiten Elektrode angeordnete lichtemittierende Schicht, wobei die lichtemittierende Schicht einen Wirt und einen Dotierstoff umfasst, wobei der Wirt eine Verbindung auf Naphthylanthracen-Basis sowie eine Verbindung auf Bianthracen-Basis umfasst.

2. Die Vorrichtung nach Anspruch 1, wobei die Verbindung auf Naphthylanthracen-Basis durch Formel 1 dargestellt ist: 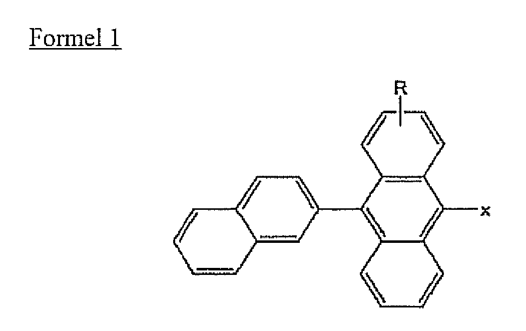 wobei R aus der aus Wasserstoff, einer substituierten oder nicht substituierten C1-C20-Alkylgruppe, einer substituierten oder nicht substituierten C1-C20-Alkoxygruppe, einer substituierten oder nicht substituierten C6-C20-Arylgruppe, einer substituierten oder nicht substituierten C6-C20-Aryloxygruppe und einer substituierten oder nicht substituierten C2-C20-Heteroarylgruppe bestehenden Gruppe ausgewählt ist;
wobei x aus der aus einer substituierten oder nicht substituierten Naphthylgruppe, einer substituierten oder nicht substituierten Biphenylgruppe, einer substituierten oder nicht substituierten Naphthylphenylgruppe und einer substituierten oder nicht substituierten Anthracenylphenylgruppe bestehenden Gruppe ausgewählt ist.

3. Die Vorrichtung nach Ansprüchen 1 oder 2, wobei die Verbindung auf Bianthracen-Basis durch Formel 2 dargestellt ist: 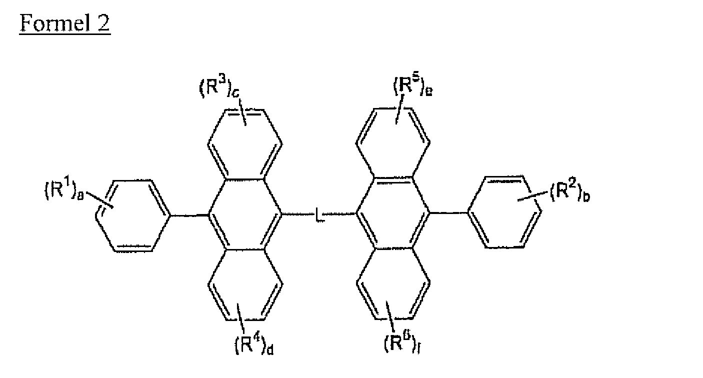 wobei jedes von R¹ bis R⁶ unabhängig aus der aus Wasserstoff, einer substituierten oder nicht substituierten C1-C20-Alkylgruppe, einer substituierten oder nicht substituierten C5-C10-Cycloalkylgruppe, einer substituierten oder nicht substituierten C2-C20-Alkenylgruppe, einer substituierten oder nicht substituierten C6-C20-Arylgruppe, einer substituierten oder nicht substituierten C1-C20-Alkoxygruppe, einer substituierten oder nicht substituierten C6-C20-Aryloxygruppe, einer substituierten oder nicht substituierten C1-C20-Alkylaminogruppe, einer substituierten oder nicht substituierten C6-C20-Arylaminogruppe und einer substituierten oder nicht substituierten heterocyclischen C2-C20-Gruppe bestehenden Gruppe ausgewählt ist, wobei eines oder mehrere von R¹ bis R⁶ durch Bindung an zwei oder mehr Benzolringe einen Ring bilden können;
wobei jedes von *a* und *b* unabhängig eine ganze Zahl aus 0, 1, 2, 3, 4 oder 5 ist;
wobei jedes von *c*, *d, e* und *f* unabhängig eine ganze Zahl aus 1, 2, 3 oder 4 ist; und
wobei *L* aus der aus keinem Atom, -O-, -S-, -N(R')-, einer C6-C20-Arylengruppe und einer C6-C20-Arylgruppe bestehenden Gruppe ausgewählt ist und R' eine C1-C10-Alkylgruppe ist.

4. Die Vorrichtung nach Anspruch 2, wobei die durch Formel 1 dargestellte Verbindung die durch Formel 3 oder Formel 4 dargestellte Verbindung ist:

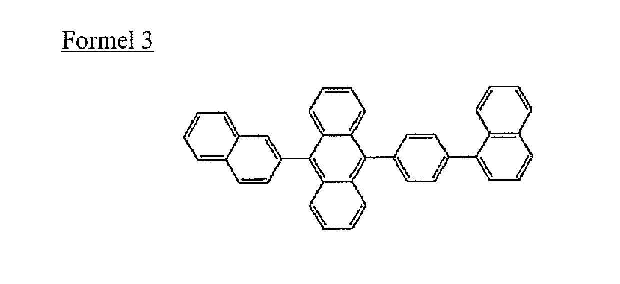

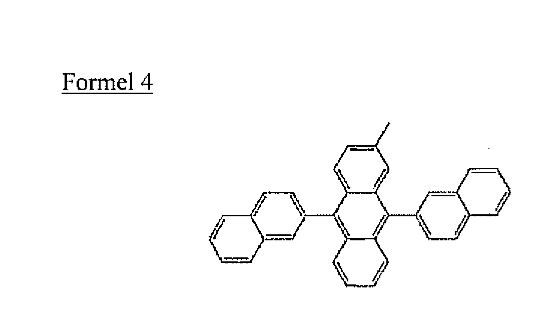

5. Die Vorrichtung nach Anspruch 3, wobei die durch Formel 2 dargestellte Verbindung die durch Formel 5 oder Formel 6 dargestellte Verbindung ist:

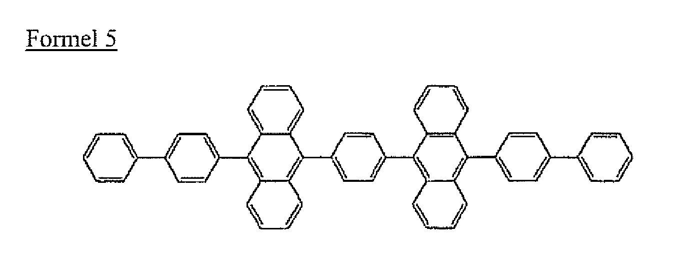

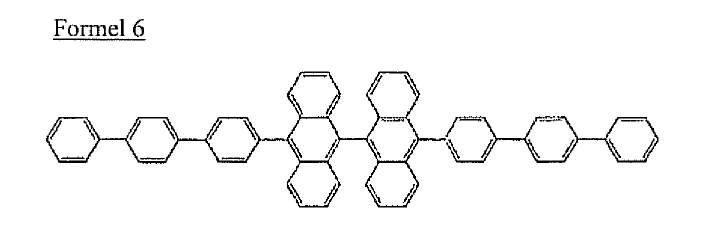

6. Die Vorrichtung nach einem der vorangehenden Ansprüche, wobei der Dotierstoff ein blaues Licht emittierendes Material umfasst.

7. Die Vorrichtung nach einem der vorangehenden Ansprüche, wobei der Dotierstoff eine durch Formel 8 dargestellte Verbindung umfasst: 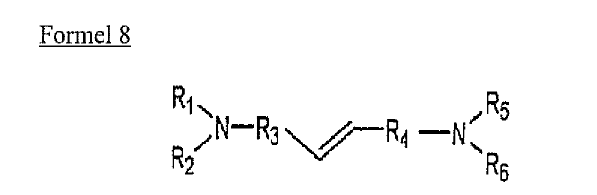 wobei jedes von R₁, R₂, R₅ und R₆ unabhängig eine substituierte oder nicht substituierte C6-C20-Arylgruppe ist; und
wobei jedes von R₃ und R₄ unabhängig eine substituierte oder nicht substituierte C6-C20-Arylengruppe ist.

8. Die Vorrichtung nach Anspruch 7, wobei der Dotierstoff ausgewählt ist, aus der Gruppe bestehend aus einer Verbindung nach Formel 8, in der jedes von R₁, R₂, R₅ und R₆ eine Phenylgruppe ist und jedes von R₃ und R₄ eine Phenylengruppe ist;
einer Verbindung nach Formel 8, in der jedes von R₁ und R₅ eine Phenylgruppe ist, jedes von R₂ und R₆ eine Naphthylgruppe ist und jedes von R₃ und R₄ eine Phenylengruppe ist; und
einer Verbindung nach Formel 8, in der jedes von R₁ und R₅ eine Naphthylgruppe ist, jedes von R₂ und R₆ eine Phenylgruppe ist und jedes von R₃ und R₄ eine Naphthalengruppe ist.

9. Die Vorrichtung nach Anspruch 7 oder 8, wobei der Dotierstoff die durch Formel 7 dargestellte Verbindung umfasst:

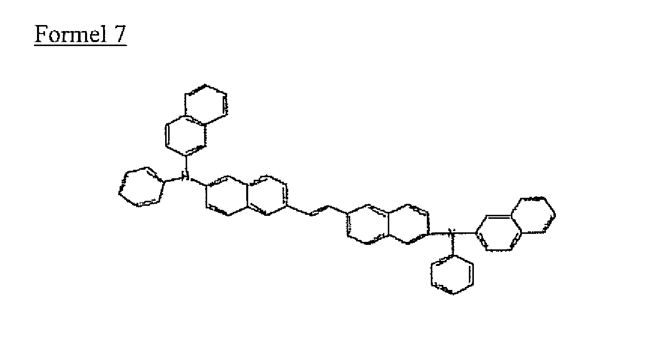

10. Die Vorrichtung nach einem der vorangehenden Ansprüche, wobei ein Gewichtsverhältnis der Verbindung auf Naphthylanthracen-Basis zu der Verbindung auf Bianthracen-Basis von ungefähr 10:90 bis ungefähr 90:10 beträgt, insbesondere von ungefähr 25:75 bis ungefähr 75:25.

11. Die Vorrichtung nach einem der vorangehenden Ansprüche, wobei der Dotierstoff in einer Menge von ungefähr 3 bis ungefähr 7 Gewichtsanteilen basierend auf 100 Gewichtsanteilen des Wirtsmaterials vorhanden ist.

12. Die Vorrichtung nach einem der vorangehenden Ansprüche 1 bis 11, wobei die lichtemittierende Schicht eine durch Formel 3 dargestellte Verbindung sowie eine durch Formel 5 dargestellte Verbindung umfasst:

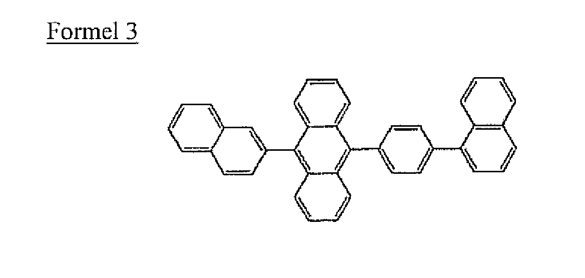

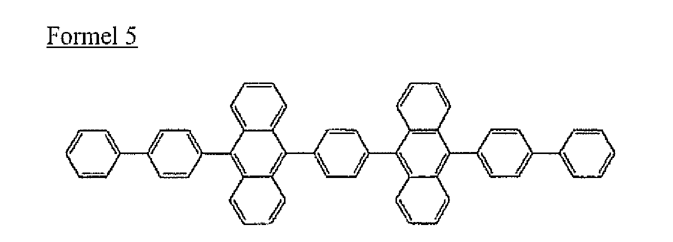

13. Die Vorrichtung nach Anspruch 12, wobei ein Gewichtsverhältnis der durch Formel 3 dargestellten Verbindung zu der durch Formel 5 dargestellten Verbindung von ungefähr 75:25 bis ungefähr 25:75 beträgt.

14. Die Vorrichtung nach Anspruch 12 oder 13, wobei die lichtemittierende Schicht ferner einen durch Formel 7 dargestellten Dotierstoffumfasst:

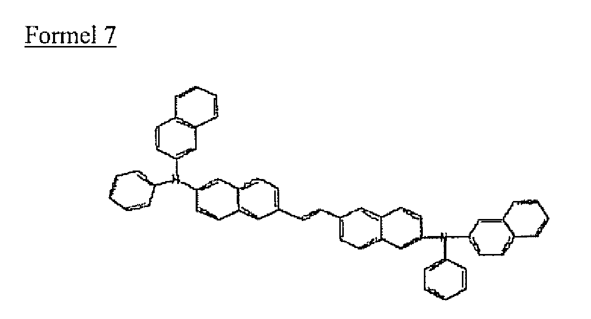

15. Die Vorrichtung nach Anspruch 14, wobei der Dotierstoff in einer Menge von ungefähr 3 bis ungefähr 7 Gewichtsanteilen basierend auf 100 Gewichtsanteilen des Wirtsmaterials vorhanden ist.

16. Die Vorrichtung nach einem der vorangehenden Ansprüche 1 bis 11, wobei die lichtemittierende Schicht eine durch Formel 3 dargestellte Verbindung sowie eine durch Formel 6 dargestellte Verbindung umfasst:

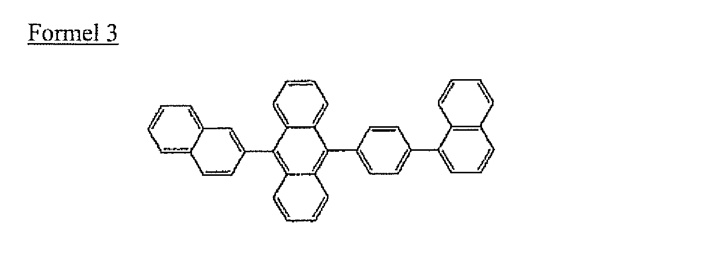

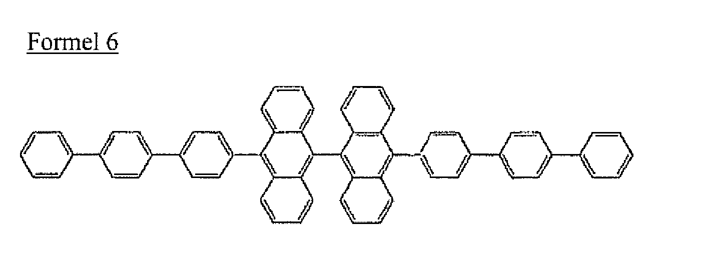

17. Die Vorrichtung nach einem der vorangehenden Ansprüche 1 bis 11, wobei die lichtemittierende Schicht eine durch Formel 4 dargestellte Verbindung sowie eine durch Formel 5 dargestellte Verbindung umfasst:

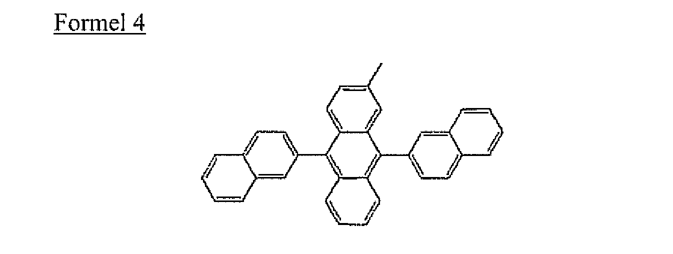

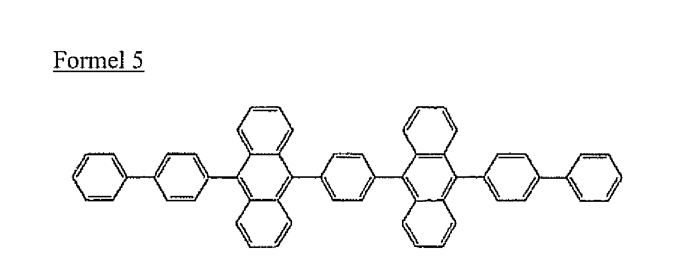

18. Die Vorrichtung nach einem der vorangehenden Ansprüche 1 bis 11, wobei die lichtemittierende Schicht eine durch Formel 4 dargestellte Verbindung sowie eine durch Formel 6 dargestellte Verbindung umfasst:

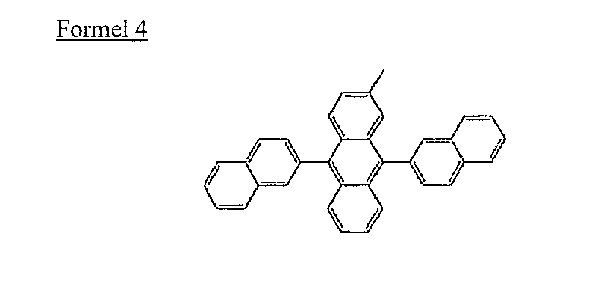

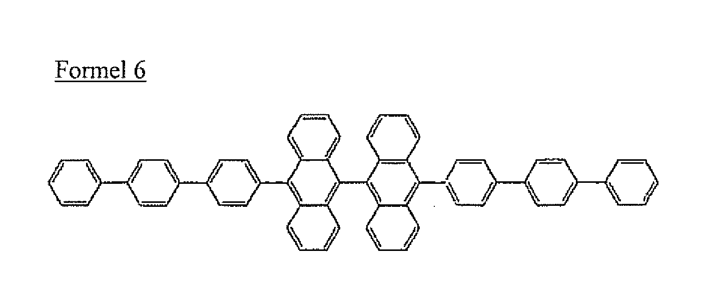

19. Die Vorrichtung nach Anspruch 16, 17 oder 18, wobei die lichtemittierende Schicht ferner einen durch Formel 7 dargestellten Dotierstoff umfasst:

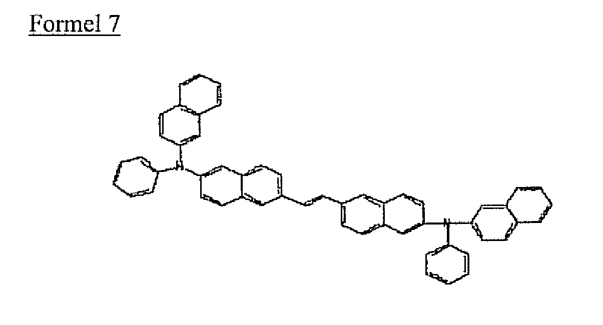

20. Eine elektronische Anzeigevorrichtung, die mindestens eine organische lichtemittierende Vorrichtung nach einem der Ansprüche 1 bis 19 umfasst.

## Revendications

1. Dispositif électroluminescent organique, comprenant :
une première électrode ;
une seconde électrode ; et
une couche émettrice de lumière intercalée entre la première électrode et la seconde électrode, la couche émettrice de lumière comprenant un hôte et un dopant, l'hôte comprenant un composé à base de naphtylanthracène et un composé à base de bianthracène.

2. Dispositif selon la revendication 1, dans lequel le composé à base de naphtylanthracène est représenté par la Formule 1 : 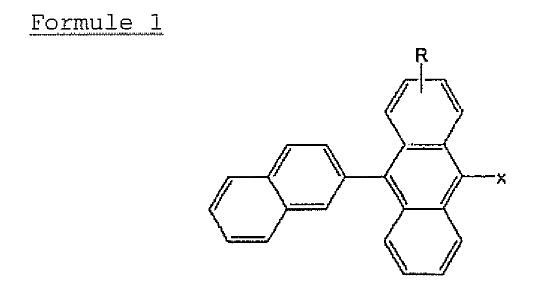 dans laquelle
R est choisi dans le groupe formé par l'hydrogène, un groupe alkyle en C₁ à C₂₀ substitué ou non substitué, un groupe alkoxy en C₁ à C₂₀ substitué ou non substitué, un groupe aryle en C₆ à C₂₀ substitué ou non substitué, un groupe aryloxy en C₆ à C₂₀ substitué ou non substitué, et un groupe hétéroaryle en C₂ à C₂₀ substitué ou non substitué ;
x est choisi dans le groupe formé par un groupe naphtyle substitué ou non substitué, un groupe biphényl substitué ou non substitué, un groupe naphtylphényle substitué ou non substitué et un groupe anthracénylphényle substitué ou non substitué.

3. Dispositif selon la revendication 1 ou 2, dans lequel le composé à base de bianthracène est représenté par la Formule 2 : 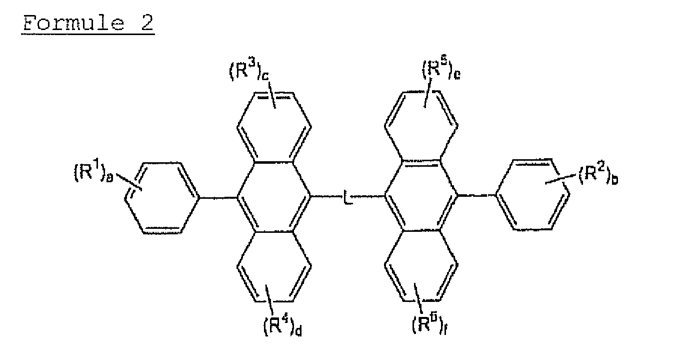 dans laquelle
chacun de R¹ à R⁶ est choisi indépendamment dans le groupe formé par l'hydrogène, un groupe alkyle en C₁ à C₂₀ substitué ou non substitué, un groupe cycloalkyle en C₅ à C₁₀ substitué ou non substitué, un groupe alcényle en C₂ à C₂₀ substitué ou non substitué, un groupe aryle en C₆ à C₂₀ substitué ou non substitué, un groupe alkoxy en C₁ à C₂₀ substitué ou non substitué, un groupe aryloxy en C₆ à C₂₀ substitué ou non substitué, un groupe alkylamino en C₁ à C₂₀ substitué ou non substitué, un groupe arylamino en C₆ à C₂₀ substitué ou non substitué, et un groupe hétérocyclique en C₂ à C₂₀ substitué ou non substitué, un ou plusieurs de R¹ à R⁶ pouvant former un cycle par liaison à deux ou plus de deux noyaux benzéniques ;
chacun de *a* et *b* étant indépendamment un nombre entier 0, 1, 2, 3, 4 ou 5 ;
chacun de c, d, e et f étant indépendamment un nombre entier 1, 2, 3 ou 4 ; et
L est choisi dans le groupe formé par l'absence d'atome, -O-, -S-, -N(R')-, un groupe arylène en C₆ à C₂₀ et un groupe aryle en C₆ à C₂₀, et R' est un groupe alkyle en C₁ à C₁₀.

4. Dispositif selon la revendication 2, dans lequel le composé représenté par la formule 1 est le composé représenté par la Formule 3 ou la Formule 4 :

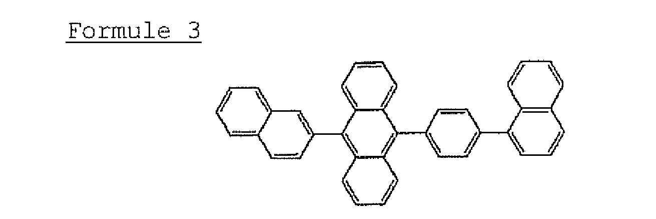

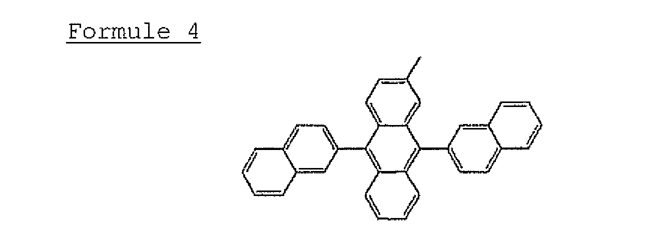

5. Dispositif selon la revendication 3, dans lequel le composé représenté par la Formule 2 est le composé représenté par la Formule 5 ou la Formule 6 :

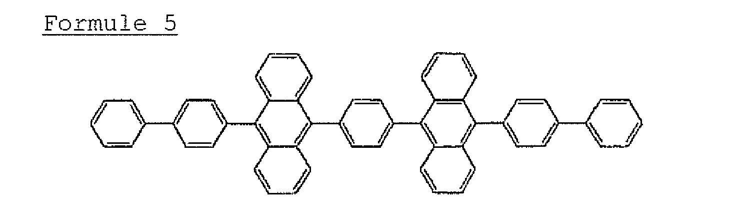

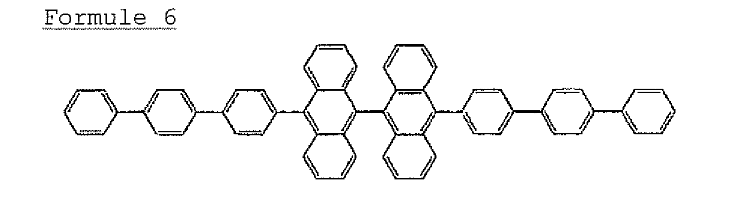

6. Dispositif selon l'une des revendications précédentes, dans lequel le dopant comprend une matière émettrice de lumière bleue.

7. Dispositif selon l'une des revendications précédentes, dans lequel le dopant comprend un composé représenté par la Formule 8 : 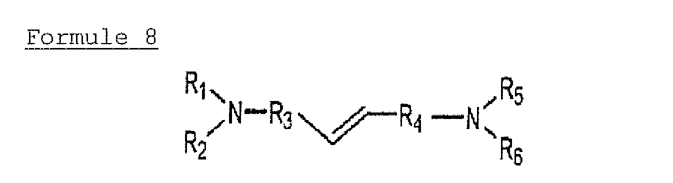 dans laquelle
R₁, R₂, R₅ et R₆ sont chacun indépendamment un groupe aryle en C₆ à C₂₀ substitué ou non substitué ; et
R₃ et R₄ sont chacun indépendamment un groupe arylène en C₆ à C₂₀ substitué ou non substitué.

8. Dispositif selon la revendication 7, dans lequel le dopant est un composé choisi dans le groupe formé par
un composé de Formule 8, dans lequel chacun de R₁, R₂, R₅ et R₆ est un groupe phényle, et chacun de R₃ et R₄ est un groupe phénylène ;
un composé de Formule 8, dans lequel chacun de R₁ et R₅ est un groupe phényle, chacun de R₂ et R₆ est un groupe naphtyle, et chacun de R₃ et R₄ est un groupe phénylène ; et
un composé de Formule 8, dans lequel chacun de R₁ et R₅ est un groupe naphtyle, chacun de R₂ et R₆ est un groupe phényle, et chacun de R₃ et R₄ est un groupe naphtalène.

9. Dispositif selon la revendication 7 ou 8, dans lequel le dopant comprend le composé représenté par la Formule 7 :

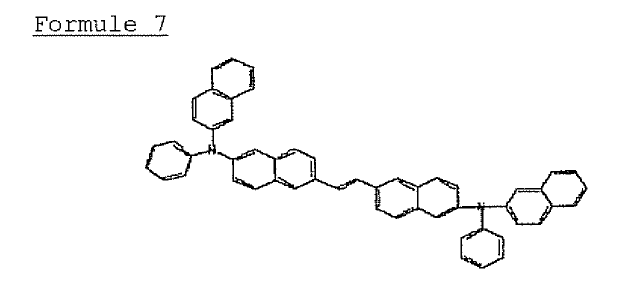

10. Dispositif selon l'une des revendications précédentes, dans lequel le rapport en poids du composé à base de naphtylanthracène au composé à base de bianthracène est d'environ 10:90 à environ 90:10, en particulier d'environ 25:75 à environ 75:25.

11. Dispositif selon l'une des revendications précédentes, dans lequel le dopant est présent en une quantité d'environ 3 à environ 7 parties en poids pour 100 parties en poids des matières hôtes.

12. Dispositif selon l'une des revendications 1 à 11 précédentes, dans lequel la couche émettrice de lumière comprend un composé représenté par la Formule 3 et un composé représenté par la Formule 5 :

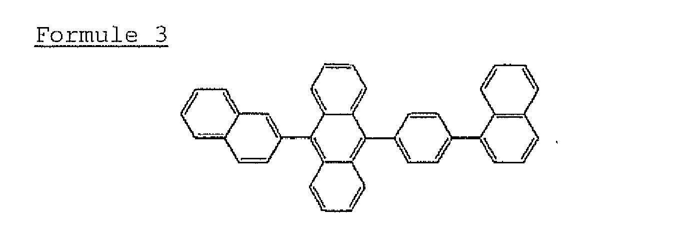

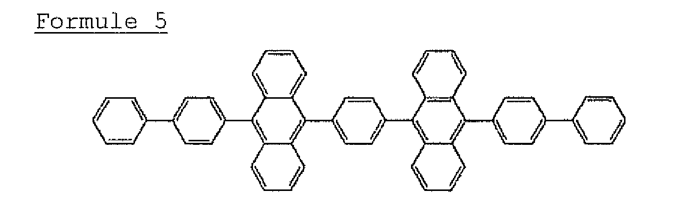

13. Dispositif selon la revendication 12, dans lequel le rapport en poids du composé représenté par la Formule 3 au composé représenté par la Formule 5 est d'environ 75:25 à environ 25:75.

14. Dispositif selon la revendication 12 ou 13, dans lequel la couche émettrice de lumière comprend de plus un dopant représenté par la Formule 7

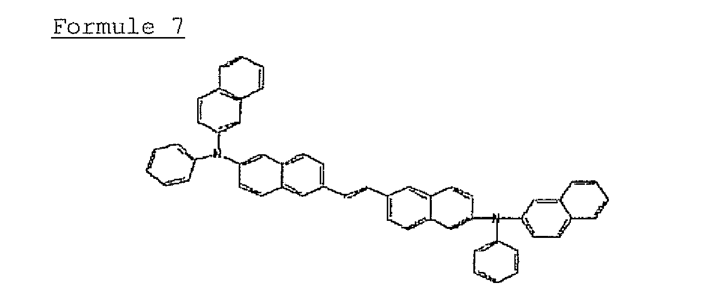

15. Dispositif selon la revendication 14, dans lequel le dopant est présent en une quantité d'environ 3 à environ 7 parties en poids pour 100 parties en poids des matières hôtes.

16. Dispositif selon l'une des revendications 1 à 11 précédentes, dans lequel la couche émettrice de lumière comprend un composé représenté par la Formule 3 et un composé représenté par la Formule 6 :

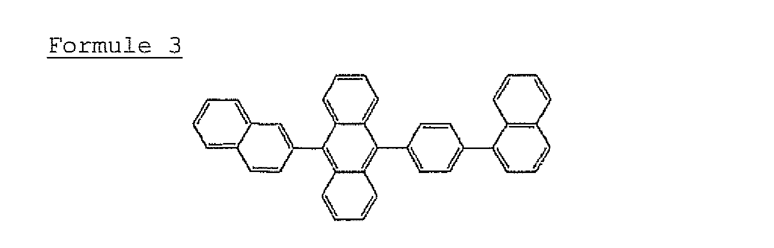

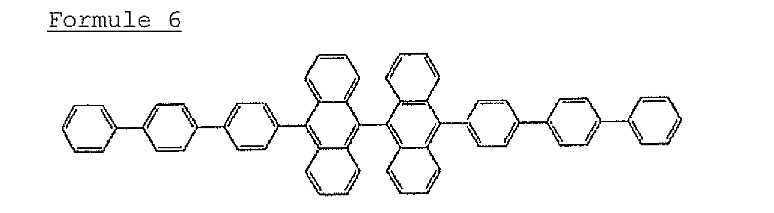

17. Dispositif selon l'une des revendications 1 à 11 précédentes, dans lequel la couche émettrice de lumière comprend un composé représenté par la Formule 4 et un composé représenté par la Formule 5 :

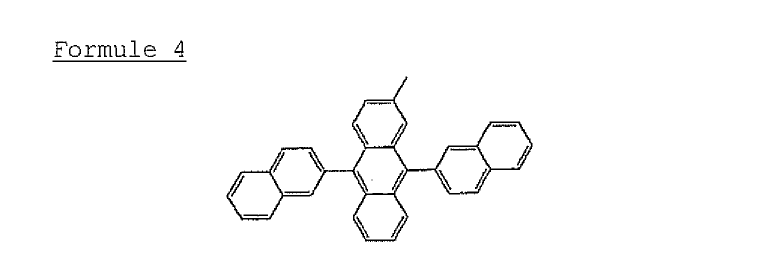

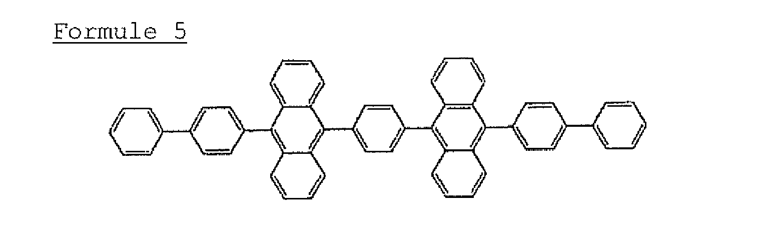

18. Dispositif selon l'une des revendications 1 à 11 précédentes, dans lequel la couche émettrice de lumière comprend un composé représenté par la Formule 4 et un composé représenté par la Formule 6 :

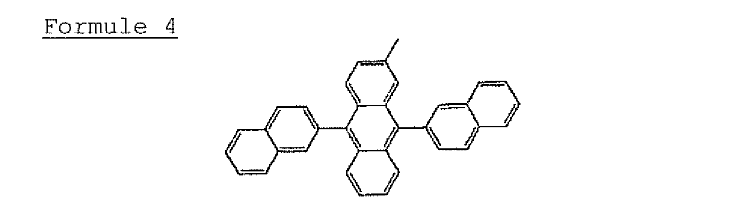

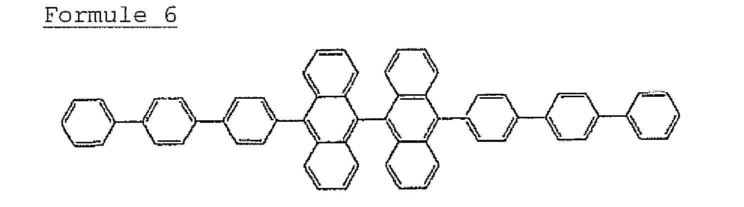

19. Dispositif selon la revendication 16, 17 ou 18, dans lequel la couche émettrice de lumière comprend de plus un dopant représenté par la Formule 7 :

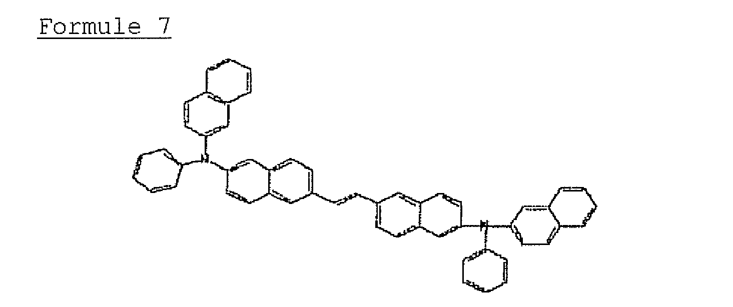

20. Dispositif d'affichage électronique comprenant au moins un dispositif électroluminescent organique selon l'une des revendications 1 à 19.
